# EUROPÄISCHE PATENTANMELDUNG

(11) **EP 2 634 428 A1**
(43) Veröffentlichungstag der Anmeldung: **04.09.2013**
(21) Anmeldenummer: 12157922.1
(22) Anmeldetag: 02.03.2012
(51) Int. Cl.: F04B 45/04, F04B 45/047, F04B 49/06, F04B 51/00, H05K 7/20

(54) **Elektrisches Gerät mit einer Kühlvorrichtung**

(71) Anmelder: Siemens Aktiengesellschaft, 80333 München (DE)
(72) Erfinder: Neubert, Axel, 76275 Ettlingen (DE); Schlotter, Theo, 76189 Karlsruhe (DE)

(57) **Zusammenfassung**

Elektrisches Gerät (100) mit einer Kühlvorrichtung, umfassend einen Schwingmembranlüfter (1) mit einer Kammer (13,14), einem Antrieb (11), einer Luftaustrittsöffnung (15,16), wobei der Antrieb (11) die Membran (12) anregt und eine dadurch erzeugte Luftpulsierung über die Luftaustrittsöffnung (15,16) abgegeben wird und zur Kühlung auf einen zu kühlenden Bereich (10) gerichtet ist, wobei der Antrieb (11) mit einer Ansteuereinheit (2), welche ein Ansteuersignal (20) zum Ansteuern des Antriebs (11) bereitstellt, verbunden ist, wobei einen Wandler (3), welcher ausgestaltet ist akustische Signale in elektrische Signale zu Wandeln, wobei der Wandler (3) mit einer Vergleichseinheit (6) in Verbindung steht und ihr zum einen das elektrische Signal des Wandlers (3) und zum anderen das Ansteuersignal (20) zugeführt ist, dabei ist die Vergleichseinheit (6) ausgestaltet das elektrische Signal des Wandlers (3) mit dem Ansteuersignal (20) zu Vergleichen und bei einer vorgebbaren Abweichung zwischen den beiden Signalen ein Alarmsignal auszugeben, wodurch eine Überwachung des Schwingmembranlüfter (1) gegeben ist.

## Beschreibung

Die Erfindung betrifft ein elektrisches Gerät mit einer Kühlvorrichtung, umfassend einen Schwingmembranlüfter mit einer Kammer, einem Antrieb, einer Luftaustrittsöffnung, wobei der Antrieb die Membran anregt und eine dadurch erzeugte Luftpulsierung über die Luftaustrittsöffnung abgegeben wird und zur Kühlung auf einen zu kühlenden Bereich gerichtet ist, wobei der Antrieb mit einer Ansteuereinheit, welcher ein Ansteuersignal zum Ansteuern des Antriebs bereitstellt, verbunden ist.

Neben den bekannten Propeller- oder Radiallüftern sind Lüfter bekannt, deren beweglichen Teile reibungsfrei und ohne Berührung zueinander gelagert sind. Deren Aufbau ist in gewisser Weise mit einem Lautsprecher vergleichbar. Lüfter dieser Art sind im englischen Sprachraum unter den Begriff "Jet Cooler" bzw. "Jet Generator" bekannt geworden und werden nachfolgend als Schwingmembranlüfter bezeichnet. Diese weisen eine in einem Gehäuse gehaltene Schwingmembran auf, welche von einem in einer Aktuatorkammer befindlichen Magnetsystem angeregt wird. Die von der Schwingmembran erzeugte Luftpulsierung wird nach außen gegeben. Ist der Schwingmembranlüfter z.B. im Inneren eines Gehäuses eines elektrischen Gerätes platziert, so verursacht er darin Luftverwirbelungen. Hiermit kann die, z.B. von Elektronikbauelementen und Prozessoren, erzeugte Verlustwärme verwirbelt und von den Wärmequellen abgeführt werden.

Ein derartiger Schwingmembranlüfter ist aus der EP 2 204 582 B1 bekannt. Auch wird in den Schriften EP 1 415 342 B1 und EP 1 762 725 A1 jeweils ein elektrisches Gerät mit einer Kühlvorrichtung umfassend einen Schwingmembranlüfter beschrieben.

War es zuvor bekannt bei Propeller- oder Radiallüftern eine Überwachung des Propeller- oder Radiallüfters mit einer Überwachung der Drehzahl des Lüfters zu realisieren, so ist es bei den bekannten Schwingmembranlüftern von Nachteil, dass es eine derartige Überwachung auf eine Funktion des Schwingmembranlüfters nicht gibt.

Es ist daher die Aufgabe der Erfindung ein elektrisches Gerät mit einer Kühlvorrichtung, umfassend einen Schwingmembranlüfter derart weiter zu bilden, dass eine Aussage darüber getroffen werden kann, ob der in dem elektrischen Gerät angeordnete Schwingmembranlüfter einwandfrei funktioniert.

Die Aufgabe wird für das eingangs genannte elektrische Gerät dadurch gelöst, dass ein Wandler in dem elektrischen Gerät angeordnet ist, welcher ausgestaltet ist akustische Signale in elektrische Signale zu wandeln, wobei der Wandler mit einer Vergleichseinheit in Verbindung steht und ihr zum Einen das elektrische Signal des Wandlers und zum Anderen das Ansteuersignal zugeführt ist, dabei ist die Vergleichseinheit ausgestaltet das elektrische Signal des Wandlers mit dem Ansteuersignal zu vergleichen und bei einer vorgebbaren Abweichung zwischen den beiden Signalen ein Alarmsignal auszugeben, wodurch eine Überwachung des Schwingmembranlüfters gegeben ist.

In einer weiteren Ausgestaltung weist das elektrische Gerät eine Auswerteeinheit auf, welche ausgestaltet ist das elektrische Signal des Wandlers derart einer Signalanalyse zu unterziehen, dass es mit einer Mehrzahl von in der Auswerteeinheit hinterlegten Referenzsignalen vergleichbar ist, wobei die Referenzsignale einen Verschleiß oder Verschmutzungsgrad des Schwingmembranlüfters repräsentieren. Hierdurch kann eine Gut-/Schlechtaussage, ob ein Schwingmembranlüfter läuft oder nicht, weiter verbessert werden. Insbesondere bei dem Einsatz von elektrischen Geräten in rauen Industrieumgebungen kann ein Schwingmembranlüfter verschmutzen und ist daher bei einem Leistungsabfall nicht zwingend gänzlich ausgefallen, sondern seine Kühlkapazität ist beispielsweise von 100% auf 80% gesunken. Es kann frühzeitig eine Prognose darüber gegeben werden, dass der Schwingmembranlüfter zwar noch ausreichend arbeitet aber das elektrische Gerät, beispielsweise ein Automatisierungsgerät, hinsichtlich seiner Kühleinheit rechtzeitig gewartet werden muss. Die hinterlegten unterschiedlich abgestuften Referenzsignale können Signale sein, welche in gewissen Grenzen von einer Sollfrequenz oder einer Sollamplitude abweichen. Durch die mit den Referenzsignalen vorgegebenen Abweichungen bezüglich der Frequenz oder der Amplitude ist es möglich eine Aussage über den Grad der Verschmutzung zu geben.

Die Kühlvorrichtung in dem elektrischen Gerät wird weiter verbessert wenn zwischen dem Wandler und der Vergleichseinheit ein Verstärker und ein elektrisches Filter geschaltet sind. Wenn beispielsweise ein Mikrofon als Wandler mit dem Verstärker verbunden ist und ein nachgeschaltetes Filter ein Messsignal erzeugt, welches in der Auswerteeinheit mit der beispielsweise sinusförmigen Ansteuerspannung verglichen wird, so ist es vorteilhaft um etwaige Fehlmessungen durch andere Geräuschquellen auszuschließen, dass elektrische Filter zwischen dem Verstärker und der Vergleichseinheit anzuordnen.

In einer weiteren Ausgestaltung des elektrischen Gerätes ist ein Gleichrichter mit der Ansteuereinheit und der Vergleichseinheit verbunden, wodurch eine Versorgungsspannung für die Vergleichseinheit bereitgestellt ist. Auch kann der Gleichrichter mit der Auswerteeinheit zur Versorgung der Auswerteeinheit mit einer Versorgungsspannung verbunden sein. Der Einsatz einer Kühlvorrichtung, insbesondere eines Schwingmembranlüfters, in einem elektrischen Gerät wird hierdurch erleichtert, da die Versorgungsspannung für die Überwachungseinrichtung des Schwingmembranlüfters vorteilhafter Weise direkt durch einen AC/DC-Wandler aus der Ansteuereinheit des Schwingmembranlüfters gewonnen werden kann, damit ist keine weitere Versorgungsspannungseinrichtung erforderlich.

Insbesondere bei einer Anwendung von elektrischen Geräten innerhalb eines industriellen Prozessautomatisierungsumfeldes, bei welchem in der Regel raue Umgebungsbedingungen, wie z.B. erhöhte Lufttemperatur, erhöhte Staubbelastung, erhöhte Luftfeuchtigkeit, erhöhte Vibrationen existieren, ist es von besonderem Vorteil, wenn das elektrische Gerät als eine industrielle Steuerung für einen zu automatisierenden industriellen Prozess, vorzugsweise als ein Industrie-Computer, insbesondere als eine speicherprogrammierbare Steuerung, ausgestaltet ist.

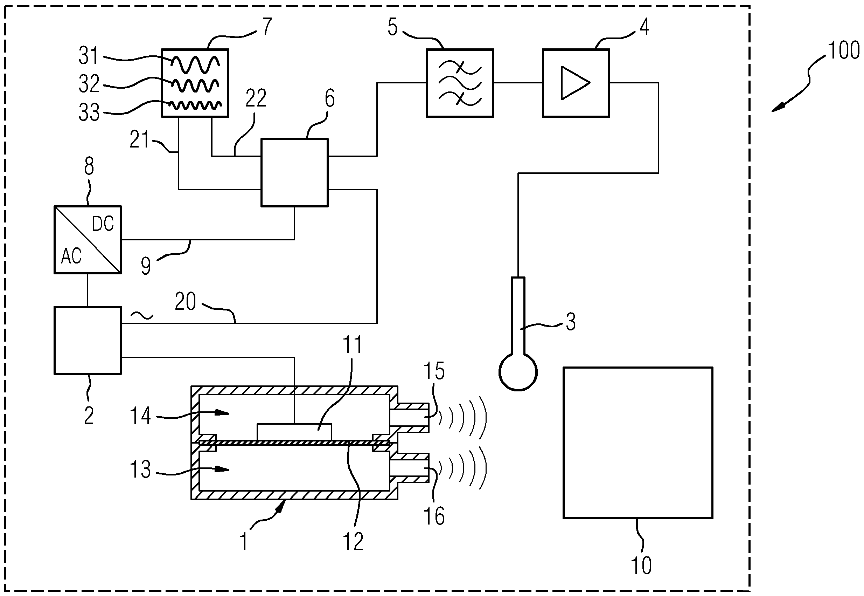

### Die Zeichnung zeigt ein Ausführungsbeispiel.

Gemäß der Figur ist ein elektrisches Gerät 100 mit einer Kühlvorrichtung, umfassend einen Schwingmembranlüfter 1 mit einer ersten Kammer 13 und einer zweiten Kammer 14, einem Antrieb 11 und einer Membran 12 dargestellt. Der Antrieb 11 wird über eine Ansteuereinheit 2, beispielsweise mit einem sinusförmigen Wechselsignal mit einer Frequenz im Bereich von 80 bis 110 Hz, versorgt. Durch die sinusförmige Anregung des Antriebes 11, welcher in der Regel als ein Magnetaktuatorsystem ausgestaltet ist, wird die in der ersten Kammer 13 und der zweiten Kammer 14 enthaltene Luft in Schwingung versetzt, wodurch eine Luftpulsierung entsteht. Über eine erste Luftaustrittsöffnung 15 und eine zweite Luftaustrittsöffnung 16 kann die derart pulsierte Luft austreten und auf einen zu kühlenden Bereich 10 geleitet werden.

Um nun eine Funktionstüchtigkeit des Schwingmembranlüfters 1 zu überwachen ist zwischen dem Schwingmembranlüfter 1 und dem zu kühlenden Bereich 10 ein Wandler 3, welcher ausgestaltet ist akustische Signale in elektrische Signale zu wandeln, angeordnet. Der Wandler 3 kann beispielsweise als ein Mikrofon ausgestaltet sein.

Der Wandler 3 ist mit einer Vergleichseinheit 6 über einen Verstärker 4 und einem elektrischen Filter 5 verbunden. Die Vergleichseinheit 6 weist für Signaleingänge einen ersten Eingang und einen zweiten Eingang auf. An dem ersten Eingang liegt das elektrische Signal des Wandlers 3. An einem zweiten Eingang liegt zu Vergleichszwecken das Ansteuersignal 20 der Ansteuereinheit 2 an. Die Vergleichseinheit 6 ist ausgestaltet das elektrische Signal des Wandlers 3 mit dem Ansteuersignal 20 zu vergleichen und bei einer vorgebbaren Abweichung zwischen den beiden Signalen ein Alarmsignal auszugeben, wodurch eine Überwachung des Schwingmembranlüfters 1 gegeben ist.

Über eine Signalleitung wird ein Alarmsignal 21 von der Vergleichseinheit 6 an eine Auswerteeinheit 7 weitergegeben. Über eine weitere Signalleitung wird das durch den Wandler 3, den Verstärker 4 und das elektrische Filter 5 gewonnenes Messsignal 22 ebenfalls an die Auswerteeinheit 7 weitergegeben.

Die Vergleichseinheit 6 stellt mit dem Alarmsignal 21 bereits eine Gut-/Schlecht-Aussage über den eingesetzten Schwingmembranlüfter 1 dar, dies bedeutet im einfachsten Fall der Schwingmembranlüfter 1 läuft oder er läuft nicht.

Möchte man nun eine genauere Aussage über die Funktionstüchtigkeit des Schwingmembranlüfters 1 erhalten, so ist die Auswerteeinheit 7 vorteilhafter Weise dazu ausgestaltet, dass elektrische Signal des Wandlers 3 einer Signalanalyse zu unterziehen. In der Auswerteeinheit 7 ist eine Mehrzahl von Referenzsignalen, nämlich ein erstes Referenzsignal 31, ein zweites Referenzsignal 32, und ein drittes Referenzsignal 33 hinterlegt. In der Auswerteeinheit 7 wird das über den Wandler 3 gewonnene Messsignal 22 mit den hinterlegten Referenzsignalen 31,32,33 verglichen, wobei die Referenzsignale 31,32,33 einen Verschleiß- oder einen Verschmutzungsgrad des Schwingmembranlüfters 1 repräsentieren.

Um für die Überwachung des Schwingmembranlüfters 1 nicht eine zusätzliche Versorgungsspannung bereit stellen zu müssen, wird über einen Gleichrichter 8, welcher ausgestaltet ist, als ein AC/DC-Wandler die Ansteuerspannung des Ansteuersignals 20 in eine Gleichspannung bzw. einen Gleichstrom gewandelt und als eine Versorgungsspannung über eine Versorgungsspannungsleitung 9 der Vergleichseinheit 6 bereitgestellt.

In einem industriellen Umfeld wird das elektrische Gerät, welches ausgestaltet ist als eine industrielle Steuerung für einen zu automatisierenden industriellen Prozess mit Vorteil eingesetzt.

## Patentansprüche

1. Elektrisches Gerät (100) mit einer Kühlvorrichtung, umfassend einen Schwingmembranlüfter (1) mit einer Kammer (13,14), einem Antrieb (11), einer Luftaustrittsöffnung (15,16), wobei der Antrieb (11) die Membran (12) anregt und eine dadurch erzeugte Luftpulsierung über die Luftaustrittsöffnung (15,16) abgegeben wird und zur Kühlung auf einen zu kühlenden Bereich (10) gerichtet ist, wobei der Antrieb (11) mit einer Ansteuereinheit (2), welche ein Ansteuersignal (20) zum Ansteuern des Antriebs (11) bereitstellt, verbunden ist, **gekennzeichnet durch**
einen Wandler (3), welcher ausgestaltet ist akustische Signale in elektrische Signale zu Wandeln, wobei der Wandler (3) mit einer Vergleichseinheit (6) in Verbindung steht und ihr zum einen das elektrische Signal des Wandlers (3) und zum anderen das Ansteuersignal (20) zugeführt ist,
dabei ist die Vergleichseinheit (6) ausgestaltet das elektrische Signal des Wandlers (3) mit dem Ansteuersignal (20) zu Vergleichen und bei einer vorgebbaren Abweichung zwischen den beiden Signalen ein Alarmsignal auszugeben, wodurch eine Überwachung des Schwingmembranlüfter (1) gegeben ist.

2. Elektrisches Gerät (100) nach Anspruch 1, aufweisend eine Auswerteeinheit (7), welche ausgestaltet ist das elektrische Signal des Wandlers (3) derart einer Signalanalyse zu unterziehen, das es mit einer Mehrzahl von in der Auswerteeinheit (7) hinterlegten Referenzsignalen (31,32,33) vergleichbar ist, wobei die Referenzsignale (31,32,33) einen Verschleiß-oder Verschmutzungsgrad des Schwingmembranlüfter (1) repräsentieren.

3. Elektrisches Gerät (100) nach Anspruch 1 oder 2, wobei zwischen dem Wandler und der Vergleichseinheit (6) ein Verstärker (4) und ein elektrisches Filter (5) geschaltet sind.

4. Elektrisches Gerät (100) nach einem der Ansprüche 1 bis 3, wobei ein Gleichrichter (8) mit der Ansteuereinheit (2) und der Vergleichseinheit (6) verbunden ist, wodurch eine Versorgungsspannung für die Vergleichseinheit (6) bereitgestellt ist.

5. Elektrisches Gerät (100) nach einem der Ansprüche 1 bis 4 ausgestaltet als eine industrielle Steuerung für einen zu automatisierenden industriellen Prozess, vorzugsweise als ein Industrie-Computer, insbesondere als eine speicherprogrammierbare Steuerung.
